# EUROPEAN PATENT SPECIFICATION

(11) **EP 3 242 211 B1**
(45) Date of publication and mention of the grant of the patent: **21.11.2018**
(21) Application number: 16768908.2
(22) Date of filing: 24.03.2016
(51) Int. Cl.: G06F 13/16

(54) **MEMORY CONTROLLER**
SPEICHERSTEUERGERÄT
CONTRÔLEUR DE MÉMOIRE

(30) Priority: 25.03.2015 JP 2015063178
(43) Date of publication of application: 08.11.2017
(73) Proprietor: Aisin AW Co., Ltd., Anjo-shi, Aichi 444-1192 (JP)
(72) Inventor: NARUSE Takanobu, Anjo-shi Aichi 444-1192 (JP)
(74) Representative: Delumeau, François Guy
(86) International application number: PCT/JP2016/059472
(87) International publication number: WO 2016/153005

(56) References cited:
- WO-A1-2012/120813
- WO-A1-2014/010763
- JP-A- 2008 102 705

## Description

### TECHNICAL FIELD

The present invention relates to a memory controller for performing data transmission to a memory through a signal line.

### BACKGROUND ART

As such a technique described above, for example, Patent Literature 1 below discloses that each bit of signal lines (a data bus, in the reference) is converted into transfer data of two or more bits by a coding circuit to send the transfer data to the data bus, and the transfer data sent to the data bus is restored to original data by a decoding circuit, and thus bus noise is reduced.

In the technique of Patent Literature 1, an extreme change in which a plurality of bits of the transfer data simultaneously change from a state of a bit of "1" or a bit of "0" to a state of a bit of "0" or a bit of "1" is avoided, thereby preventing noise relative to a power supply potential or a ground potential from being generated.

However, in considering the data bus between a memory controller and a memory, since data sent to the data bus is configured by a combination of a bit of "1" and a bit of "0", it has been difficult to suppress generation of noise having a specific frequency, which is caused when a signal repeatedly changes at a certain cycle as in a case in which a bit of "1" and a bit of "0" are transmitted alternately, for example.

Furthermore, in the technique of Patent Literature 1, in order to cope with both of data written into and data read from the memory by the memory controller, both of the memory controller and the memory need the coding circuit for generating the transfer data and the decoding circuit for restoring the transfer data to the original data. Further, in the technique of Patent Literature 1, since a clock signal having a frequency twice or more of the signal change is needed, both of the memory controller and the memory need a dedicated clock generation circuit. In addition, since both of the memory controller and the memory include the coding circuit and the decoding circuit, both of the memory controller and the memory need software settings of the coding and decoding. This makes procedures of the software settings increased. From these reasons, in the technique of Patent Literature 1, there has been such problems that not only costs of both of the memory controller and the memory increase, but also the both need to secure a space for mounting the coding circuit and the decoding circuit in a circuit board.

In order to suppress influence of the noise, a metal shield is provided on a circuit board, or circuit design is modified. However, those countermeasures are cost-increasing factors, and also such modification is not easy. Therefore, there has been a problem in which flexibly taking the countermeasures in accordance with various usage environments and noise factors is difficult.

### CITATIONS LIST

### PATENT LITERATURE

Patent Literature 1: JP 11-68860 A
Document WO 2014/010763 discloses a known apparatus for managing memory.

### SUMMARY OF INVENTION

### TECHNICAL PROBLEMS

Thus, in a configuration for performing data transmission to a memory through signal lines, a technique capable of effectively suppressing noise generated in the signal lines is required.

### SOLUTIONS TO PROBLEMS

A a memory controller is proposed as set forth in any one of claims 1, 2, or 3, in view of the foregoing. The memory controller includes a write part that writes data into a memory through a signal line by specifying an address of the memory, and a read part that reads data from the memory through the signal line by specifying an address of the memory, in which
the write part includes a substitution unit that substitutes, when a linear sequence of a bit of "1" and a bit of "0" of a bit string of transmission data to be written into the memory through the signal line is a target pattern set as a substitution target, a substitutional bit string having a post-substitution pattern whose linear sequence of a bit of "1" and a bit of "0" is different from the target pattern, for an initial bit string having the target pattern, before the transmission data is written into the memory, and
the read part includes a restoration unit that restores the substitutional bit string of data read from the memory to the initial bit string.

According to this configuration, by appropriately setting the target pattern and the post-substitution pattern, another pattern is substituted for a bit string pattern that generates noise which is a problem. Therefore, the noise generated in the signal line can be reduced in both a case in which data is written into the memory and a case in which data is read from the memory.

Further, in this case, by only modifying settings of the target pattern and the post-substitution pattern in software, noise having various frequencies can be reduced. Accordingly, in comparison with a case in which noise countermeasures are taken by, for example, providing a shield that covers the signal line, or by circuit design, a noise frequency to be reduced can be easily changed. Thus, the noise countermeasures can be flexibly taken in accordance with usage environments of the memory and the memory controller.

Furthermore, according to this configuration, the function of the substitution unit and the function of the restoration unit have only to be implemented in the memory controller, and a typical memory can be used. In addition, only the memory controller needs the software settings, and thus procedures of the software settings can be simplified.

### BRIEF DESCRIPTION OF DRAWINGS

FIG. 1 is a block diagram illustrating a relationship between a memory controller and a memory.
FIG. 2 is a block diagram illustrating a configuration of the memory controller.
FIG. 3 schematically illustrates an initial bit string and a substitutional bit string.
FIG. 4 illustrates a plurality of bit strings.
FIG. 5 is a flowchart of write processing.
FIG. 6 is a flowchart of read processing.
FIG. 7 schematically illustrates data structure of an occurrence rate table.
FIG. 8 is a graph illustrating an example of an occurrence rate of a bit string pattern for each frequency.
FIG. 9 schematically illustrates data structure of pattern identification information.
FIG. 10 is a block diagram illustrating a configuration of a noise analysis device.
FIG. 11 is a flowchart of analysis processing.

### DESCRIPTION OF EMBODIMENTS

Hereinafter, embodiments of the present invention will be described with reference to the drawings.

### 1. Embodiment

### [Basic Configuration]

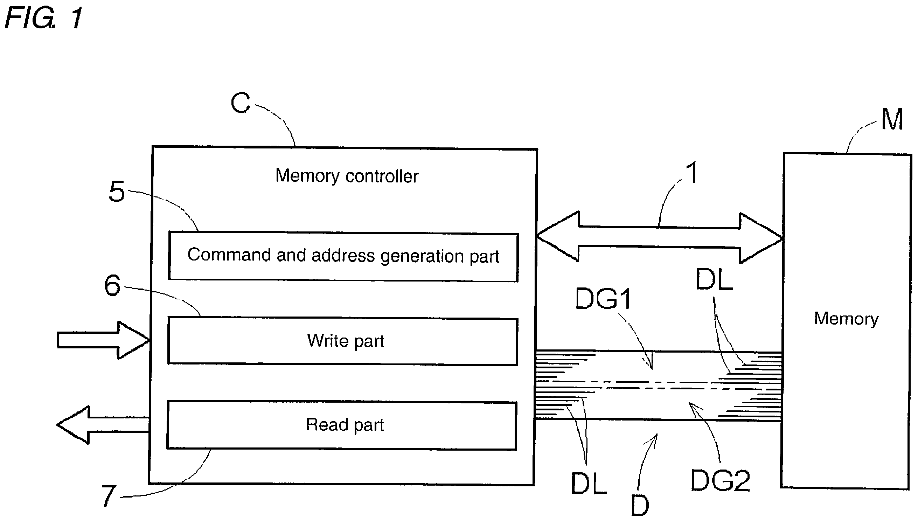

An embodiment of a memory controller C will be described with reference to the drawings. FIG. 1 illustrates the memory controller C that reads and writes data from and into a memory M. The memory M and the memory controller C are applied to not only personal computers, but also audio devices, vehicle-mounted car navigation devices, mobile communication devices, and the like.

The memory M is assumed to be a dynamic random access memory (DRAM) capable of reading and writing data in a burst mode through a data bus D of 16 bits (an example of a data transmission lane). That is, a typical memory having no specific function can be used as the memory M. Command and address lines 1 are provided between the memory M and the memory controller C. The data bus D includes a plurality of signal lines DL (16 lines) disposed in parallel. The data bus D is not limited to have 16 bits, but may have not less than 16 bits or less than 16 bits.

Further, the data bus D has a configuration in which a first transmission lane DG1 and a second transmission lane DG2, each of which is a bus of 8 bits, are disposed in parallel, and the memory controller C can control the first transmission lane DG1 and the second transmission lane DG2 independently.

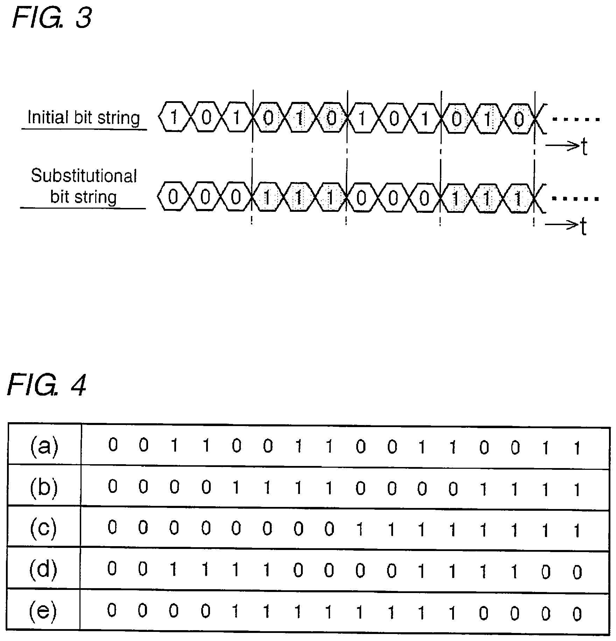

Since the plurality of signal lines DL configuring the data bus D (data transmission lanes) transmit data in synchronization with a reference clock for data transmission, when a set of data is a bit string in which a bit of "1" and a bit of "0" are continued alternately, as illustrated as an "initial bit string" in FIG. 3, for example, noise having a frequency in synchronization with the reference clock is generated. When a set of data is a bit string in which two bits of "1" and two bits of "0" are continued alternately, as illustrated in (a) in FIG. 4, for example, noise having a frequency that is half of the reference clock is generated. Specific examples of a bit string to be transmitted can include bit strings having various patterns as illustrated in (b) and (c) in FIG. 4, for example, in addition to the above-described bit strings. The noise is an electromagnetic wave and therefore may cause a problem such as generation of an unintended signal in peripheral circuits. As for noise having various frequencies generated in accordance with the patterns of the bit strings described above, a bit string pattern having a high occurrence rate may generate noise more. In addition, even when the occurrence rate is not high, noise having a specific frequency may particularly easily cause a problem, depending on a configuration of the peripheral circuits and the like.

From these reasons, as illustrated in FIG. 3 for example, when the "initial bit string" is the bit string that generates the noise having the specific frequency, the memory controller C has a function for converting the bit string into a bit string having another frequency, which is illustrated as a "substitutional bit string" in FIG. 3. In the example illustrated in FIG. 3, the "substitutional bit string" in which three bits of "1" and three bits of "0" are continued alternately to generate noise having a frequency that is 1/3 of the reference clock is substituted for the "initial bit string" in which a bit of "1" and a bit of "0" are continued alternately to generate noise having the same frequency as the reference clock. With this configuration, the noise that is generated in the signal lines DL and has the same frequency as the reference clock is reduced. Furthermore, when the substitutional bit string written into the memory M is read from the memory M, the memory controller C restores the substitutional bit string to the original bit string by performing restoration processing.

In the embodiment, the bit string of a linear sequence of a bit of "1" and a bit of "0" in transmission data that is received by the memory controller C and that is to be written into the memory M is referred to as the initial bit string. In the initial bit string, a linear sequence of a bit of "1" and a bit of "0" that is set as a substitution target is referred to as a target pattern. Furthermore, a pattern set different from the target pattern by the substitution is referred to as a post-substitution pattern, and a linear sequence of a bit of "1" and a bit of "0" of the post-substitution pattern is referred to as the substitutional bit string. In the example illustrated in FIG. 3, the bit string in which a bit of "1" and a bit of "0" are continued alternately is set as the target pattern, and the bit string in which three bits of "1" and three bits of "0" are continued alternately is set as the post-substitution pattern.

With this configuration, it is possible to reduce the noise having the specific frequency in the data transmitted through the signal lines DL, that is, the noise having the frequency, which is generated from the bit string set as the target pattern, both in a case of transmitting data to the memory M (when data is written) and a case of transmitting data from the memory M (when data is read). A way of setting a target pattern will be described later.

### [Memory Controller]

As illustrated in FIG. 1, the memory controller C includes a command and address generation part 5 that specifies a command and an address for reading and writing of data, a write part 6 that performs writing of transmission data into the memory M, and a read part 7 that performs reading of data from the memory M.

The memory controller C has a function for performing predetermined processing by executing a program, similar to a microprocessor, a digital signal processor (DSP), and the like. The memory controller C implements substitution processing and restoration processing described later by utilizing this function. In other words, in the present embodiment, both of the function of the write part 6 including a substitution unit that performs the substitution processing and the function of the read part 7 including a restoration unit that performs the restoration processing are implemented by the program in the memory controller C. According to the present embodiment, a configuration capable of effectively suppressing the noise is achieved only by using the typical memory for the memory M, and adding functions of the write part 6 and the read part 7 described below to the program in the memory controller C.

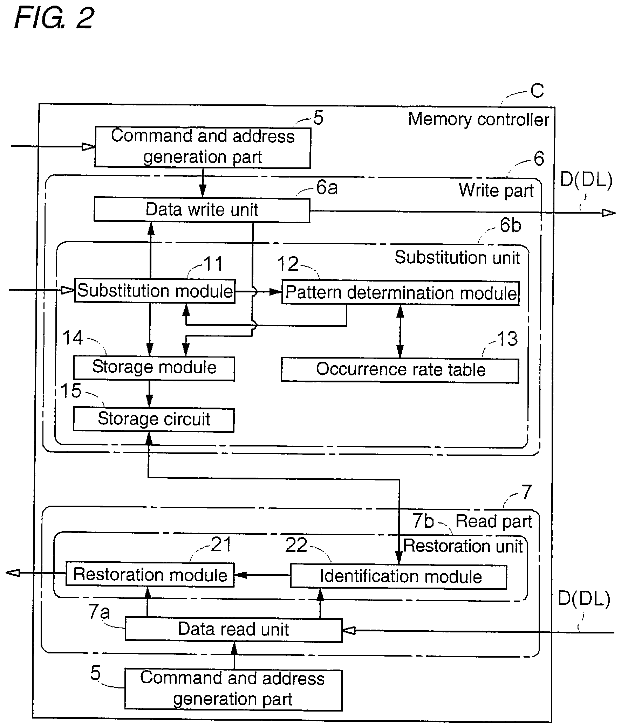

As illustrated in FIG. 2, the write part 6 includes a data write unit 6a and a substitution unit 6b. When a linear sequence of a bit of "1" and a bit of "0" of the bit string of the transmission data that is to be written into the memory M through the signal lines DL is the target pattern set as the substitution target, the substitution unit 6b performs processing for substituting the substitutional bit string whose linear sequence of a bit of "1" and a bit of "0" is the post-substitution pattern different from the target pattern for the initial bit string having the target pattern, before the transmission data is written into the memory M. For this purpose, the substitution unit 6b includes a substitution module 11, a pattern determination module 12, an occurrence rate table 13, a storage module 14, and a storage circuit 15. The pattern determination module 12 determines whether the linear sequence of a bit of "1" and a bit of "0" of the bit string of the transmission data is the preset target pattern. When the pattern determination module 12 determines that the linear sequence is the target pattern, the substitution module 11 substitutes the substitutional bit string for the initial bit string having the target pattern. When the substitution module 11 performs the substitution, the storage module 14 stores the target pattern and address data which are associated with each other, into the storage circuit 15, the address data identifying an address in the memory M into which the substitutional bit string is written. The memory controller C of the present embodiment includes the storage circuit 15 therein, but a target into which data is stored by the storage module 14 may be a region in the memory M.

The read part 7 includes a data read unit 7a and a restoration unit 7b. The restoration unit 7b performs processing for restoring the substitutional bit string of the data read from the memory M to the initial bit string. For this purpose, the restoration unit 7b includes a restoration module 21 and an identification module 22. The identification module 22 identifies the substitutional bit string contained in the data read from the memory M on the basis of the address data stored in the storage circuit 15. The restoration module 21 restores the substitutional bit string to the initial bit string before being substituted, on the basis of the target pattern associated with the address data stored in the storage circuit 15.

The data write unit 6a writes the transmission data into the memory M on the basis of information from the command and address generation part 5. Although two command and address generation parts 5 are illustrated for facilitating understanding in the same figure, the memory controller C may generally include one command and address generation part 5.

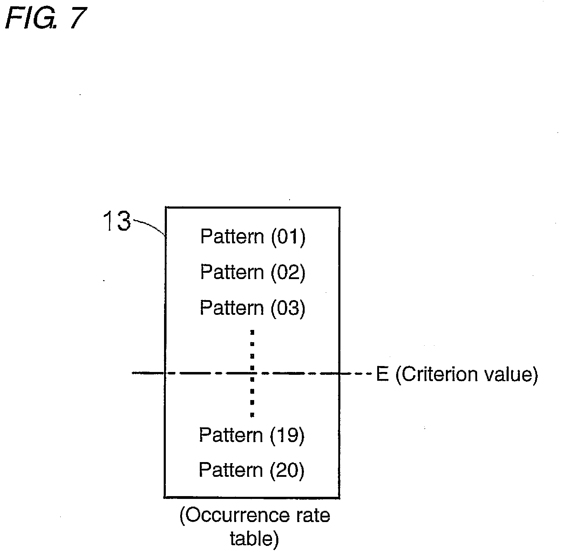

FIG. 7 illustrates an example of data structure of the occurrence rate table 13. The same figure illustrates data structure storing a plurality of target patterns including a pattern (01), pattern (02) .... pattern (20) in descending order of the occurrence rate. Furthermore, in the occurrence rate table 13, bit string information is associated with each pattern in order to distinguish each pattern from others, and a criterion value E is set for discriminating the plurality of target patterns on the basis of the occurrence rate. The occurrence rate table 13 can be obtained through analysis using a noise analysis device AN described later.

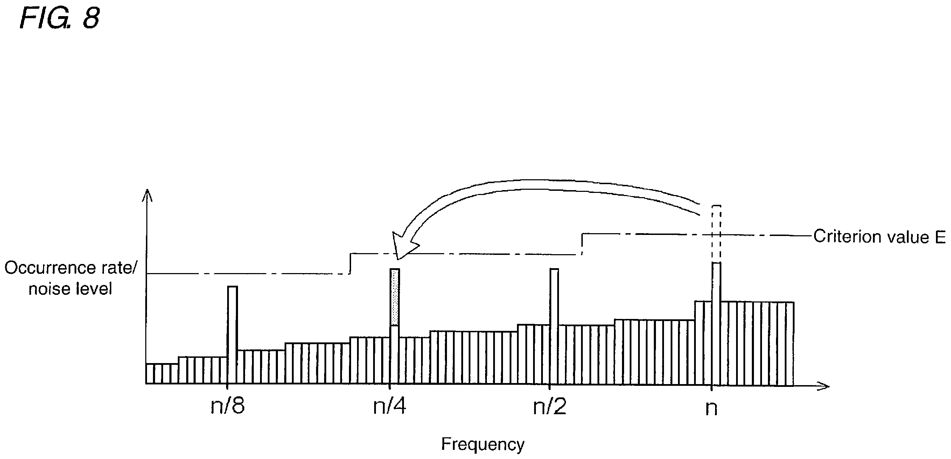

FIG. 8 is a graph illustrating an example of the occurrence rate of a bit string pattern that generates noise for each frequency, in which a frequency is represented on a horizontal axis and an occurrence rate is represented on a vertical axis. In this example, an occurrence rate of a bit string pattern that generates noise having the same frequency (frequency = n) as the reference clock is the highest, and exceeds the criterion value E. Accordingly, in the present embodiment, at least one of singular or plural bit string patterns that generate the noise having the same frequency (frequency = n) as the reference clock is set as the target pattern. In addition, in the example in FIG. 8, one of bit string patterns that generate noise having a frequency that is 1/4 of the reference clock (frequency = n/4) is set as the post-substitution pattern. With this configuration, although the noise having the frequency that is 1/4 of the reference clock (frequency = n/4) is increased, the noise having the frequency of the reference clock (frequency = n), whose occurrence rate exceeds the criterion value E, can be reduced. As a result, the occurrence rates of all frequencies are suppressed not more than the criterion value E. Here, the criterion value E can be set as, for example, an average value of an occurrence rate for each predetermined frequency band. The criterion value E may be set based on other criterions such as a mode value and a median value, instead of the average value. Further, since the occurrence rate of the bit string pattern that generates the noise for each frequency substantially is responsive to magnitude of the noise for each frequency, the vertical axis of the graph in FIG. 8 can be replaced by a noise level.

### [Processing Mode]

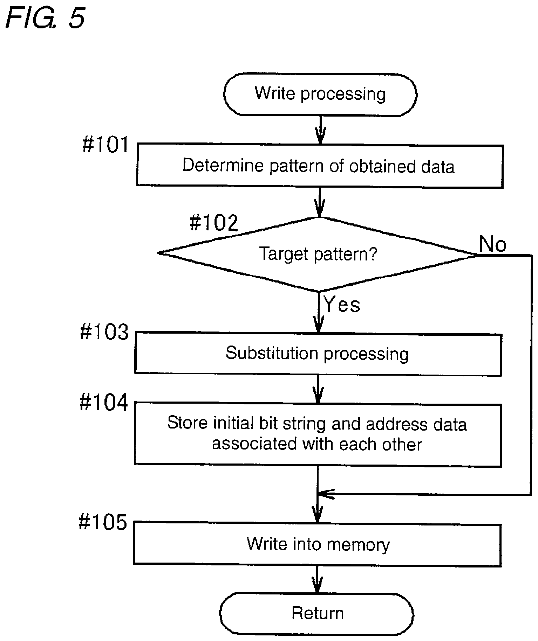

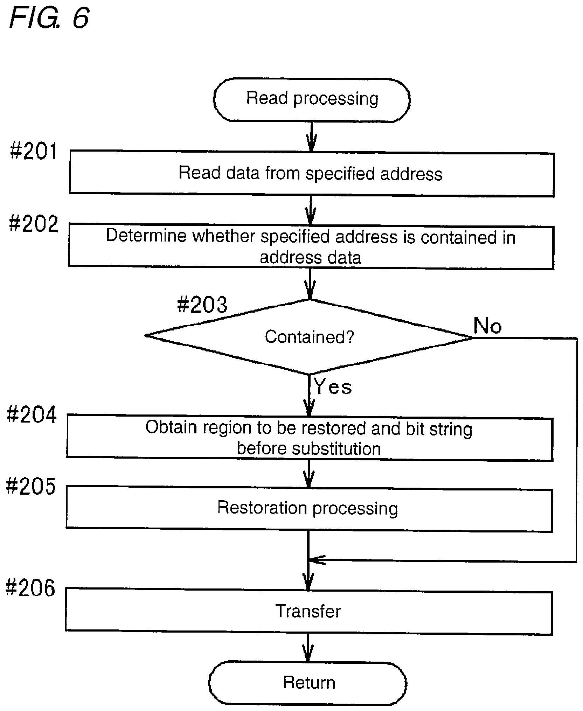

FIG. 5 is a flowchart illustrating an outline of write processing in the write part 6, and FIG. 6 is a flowchart illustrating an outline of read processing in the read part 7.

When the writing is performed, determination whether each set of the data is the bit string having the target pattern is performed on all data given to the memory controller C for writing data into the memory M in the burst mode. This determination is performed on each of the plurality of data transmission lanes (DG1, DG2) configuring the data bus D, and as a result of the determination, the processing that substitutes the substitutional bit string that is the bit string having the post-substitution pattern for the initial bit string having the target pattern (target bit string) is performed.

When the writing is performed in the burst mode, a bit length of the bit string having the target pattern is preferably set equal to a bit length transferred in the burst mode, but may be set shorter than the bit length transferred in the burst mode.

### [Processing Mode: Write Processing]

When a request for transmitting the transmission data and writing the transmission data into the memory M is issued, the write processing illustrated in the flowchart in FIG. 5 is performed. In the write processing, the bit strings of the transmission data (initial bit strings) in the plurality of data transmission lanes (DG1, DG2) are obtained, and the determination is performed on each pattern. As a result of the determination, the bit string determined as the preset target pattern is set as the substitution target (steps #101, #102).

In this processing, the substitution module 11 obtains the initial transmission data to be written into the memory M by the memory controller C, and gives the initial transmission data to the pattern determination module 12. The pattern determination module 12 performs the determination whether the linear sequences of a bit of "1" and a bit of "0" of the transmission data of the data to be transferred to the plurality of data transmission lanes (DG1, DG2) are the target pattern, referring to the occurrence rate table 13.

In other words, in this determination, when the initial bit string of the transmission data coincides with the target pattern set from patterns whose occurrence rates are higher than the criterion value E, among the plurality of patterns illustrated in FIG. 7, it is determined that the initial bit string is the bit string having the target pattern. Then, the bit string having the post-substitution pattern set from patterns whose occurrence rates are lower than the criterion value E is substituted for the initial bit string. That is, in the present embodiment, at least one of the patterns whose occurrence rates are higher than the criterion value E is set as the target pattern, and at least one of the patterns whose occurrence rates are lower than the criterion value E is set as the post-substitution pattern. Hereinafter, for simplicity of the description, the description will be made on a case in which one target pattern and one post-substitution pattern are set for each of the data transmission lanes (DG1, DG2), as an example. Although one of the patterns whose occurrence rates are lower than the criterion value E is set as the post-substitution pattern in this processing, the processing mode may be alternatively set such that a bit string that is not stored in the occurrence rate table 13 is set as the substitutional bit string. In addition, for example, all patterns whose occurrence rates are higher than the criterion value E in the occurrence rate table 13 illustrated in FIG. 7 may be set as the target patterns. In that case, the determination whether the initial bit string coincides with the target patterns is performed, by comparing bit string information associated with each pattern whose occurrence rate is higher than the criterion value E in the occurrence rate table 13 with the initial bit string of the transmission data.

The substitution module 11 performs the substitution processing for substituting the substitutional bit string corresponding to the post-substitution pattern for the initial bit string having the target pattern, based on the post-substitution pattern set as described above. In cooperation with the substitution, the storage module 14 then stores, into the storage circuit 15, the target pattern and address data which are associated with each other, the address data identifying an address in the memory M into which the substitutional bit string that is substituted as a result of coincidence of the initial bit string with the target pattern is written. Then the substitutional bit string after being substituted is written into the memory M. It is noted that, data of an initial bit string having a pattern different from the target pattern is written into the memory M without any processing (steps #103 to #105).

In this processing of this example, the storage module 14 obtains the target pattern corresponding to the initial bit string substituted by the substitution module 11 from the substitution module 11 or the pattern determination module 12, and obtains the address data for identifying the address in the memory M into which the substitutional bit string is written, from the data write unit 6a. After this, the target pattern and the address data are associated with each other to be written into the storage circuit 15.

In general, the address data is a combination of a leading address of a region in the memory M into which the substitutional bit string is written, and data of a bit length. On the other hand, as another example, a bit string that is the initial bit string that is not subjected to the substitution processing performed by the substitution module 11 and has the same pattern as the post-substitution pattern is preferably set as the target bit string whose address is to be stored. In addition, data for identifying the address in the memory M into which the target bit string is written is preferably set as the address data. As described above, the target pattern is often set using the pattern having a high occurrence rate, and the post-substitution pattern is often set using the pattern having a low occurrence rate. In such a case, the number of occurrences of the bit string that is the initial bit strings and has the same pattern as the post-substitution pattern is likely to be less than the number of occurrences of the bit string that coincides with the target pattern. Accordingly, the case of setting an address of the bit string that is the initial bit string and has the same pattern as the post-substitution pattern as the address information can reduce an amount of the address information needed to be stored in the storage circuit 15, that is data quantity, in comparison with the case of setting an address of the bit string that coincides with the target pattern as the address information.

When the plurality of data transmission lanes (DG1, DG2) are provided, as in the present embodiment, it is preferable that post-substitution patterns different from each other are respectively set to the plurality of data transmission lanes (DG1, DG2). In this case, the post-substitution patterns are preferably set such that on/off frequencies of post-substitution bit strings transmitted through the plurality of data transmission lanes (DG1, DG2) are different from each other. With this configuration, the substitution processing performed by the substitution unit 6b can suppress an increase in the noise having the specific frequency. Then, in the present embodiment, the substitution unit 6b sets a different post-substitution pattern to each of the first transmission lane DG1 and the second transmission lane DG2, such that an on/off frequency generated by a linear sequence of a bit of "1" and a bit of "0" of a substitutional bit string transmitted through the first transmission lane DG1 is different from an on/off frequency generated by a linear sequence of a bit of "1" and a bit of "0" of a substitutional bit string transmitted through the second transmission lane DG2. For example, when the post-substitution pattern of the first transmission lane DG1 is a bit string pattern illustrated in (b) in FIG. 4 and the post-substitution pattern of the second transmission lane DG2 is a bit string pattern illustrated in (c) in FIG. 4, the on/off frequency generated by the post-substitution bit string of the first transmission lane DG1 becomes a frequency that is 1/4 of the reference clock, and the on/off frequency generated by the post-substitution bit string of the second transmission lane DG2 becomes a frequency that is 1/8 of the reference clock. In this case, a target pattern for the first transmission lane DG1 and a target pattern for the second transmission lane DG2 may be the same as each other or may be different from each other. When three or more data transmission lanes are present, on/off frequencies of substitutional bit strings transmitted through the data transmission lanes are preferably set to be frequencies different from one another, but on/off frequencies of substitutional bit strings transmitted through some data transmission lanes can be the same as one another.

Further, the post-substitution patterns are preferably set such that timings of boundaries between bits of "1" and bits of "0" of the post-substitution bit strings transmitted through the plurality of data transmission lanes (DG1, DG2) is different from each other. This configuration can suppress noise increased at a timing when the timings of the boundaries between bits of "1" and bits of "0" of the post-substitution bit strings in the plurality of data transmission lanes (DG1, DG2) are the same as each other, after the substitution processing performed by the substitution unit 6b. Then, in the present embodiment, the substitution unit 6b sets a different post-substitution pattern to each of the first transmission lane DG1 and the second transmission lane DG2 such that a timing of a boundary between a bit of "1" and a bit of "0" of the substitutional bit string transmitted through the first transmission lane DG1 and a timing of a boundary between a bit of "1" and a bit of "0" of the substitutional bit string transmitted through the second transmission lane DG2 are different from each other. For example, when the post-substitution pattern of the first transmission lane DG1 is a bit string pattern illustrated in (d) in FIG. 4 and the post-substitution pattern of the second transmission lane DG2 is a bit string pattern illustrated in (e) in FIG. 4, the post-substitution bit string of the first transmission lane DG1 and the post-substitution bit string of the second transmission lane DG2 have different timings of the boundaries between bits of "1" and bits of "0" from each other, and the on/off frequencies thereof are also different from each other. Further, for example, when the post-substitution pattern of the first transmission lane DG1 is a bit string pattern illustrated in (c) in FIG. 4 and the post-substitution pattern of the second transmission lane DG2 is a bit string pattern illustrated in (e) in FIG. 4, the post-substitution bit string of the first transmission lane DG1 and the post-substitution bit string of the second transmission lane DG2 have the same on/off frequency as each other, but timings of boundaries between bits of "1" and bits of "0" are different from each other. In this case, the target pattern of the first transmission lane DG1 and the target pattern of the second transmission lane DG2 may be the same as each other or may be different from each other. When three or more data transmission lanes are present, timings of boundaries between bits of "1" and bits of "0" of substitutional bit strings transmitted through the data transmission lanes are preferably set to be different from one another, but timings of boundaries between bits of "1" and bits of "0" of the substitutional bit strings transmitted by some data transmission lanes can be the same as one another.

In any case, the substitution unit 6b performs the substitution processing that substitutes the substitutional bit string having the post-substitution pattern for the initial bit string having the target pattern, on each of corresponding data transmission lanes (DG1, DG2).

### [Processing Mode: Read Processing]

As illustrated in FIG. 6, in the read processing, when data is read from an address region that is specified (specified address region), determination whether the specified address region corresponds to an address identified by the address data stored in the storage circuit 15 is performed (steps #201, #202).

In this processing, when a read request is issued to the memory controller C and the data read unit 7a reads data from the memory M, the data read by the data read unit 7a is given to the restoration module 21. In cooperation with this operation, the data read unit 7a gives information on specified address to an identification module 22, and the identification module 22 compares the information on specified address with an address identified by the address data stored in the storage circuit 15. In this comparison, determination whether the specified address corresponds to the address identified by the address data stored in the storage circuit 15 is performed.

When the specified address is determined to correspond to the address identified by the address data stored in the storage circuit 15, the identification module 22 gives, to the restoration module 21, information on an address identified by corresponding address data and information on a target pattern associated with the address data, among the data read from the memory M. With this, the restoration module 21 performs the restoration processing on the data read from the memory M, and transfers the restored data to a requesting site. Further, when the restoration is not required, the obtained data is transmitted without any processing (steps #203 to #206).

In the description, the read processing is performed for one data transmission lane. However, when the plurality of data transmission lanes (DG1, DG2) are provided as in the present embodiment, the read processing is performed for each of the plurality of data transmission lanes (DG1, DG2), as a matter of course.

### [Settings of Occurrence Rate Table]

The occurrence rate table 13 is used for determination whether the bit string of a bit of "1" and a bit of "0" of the transfer data transferred to the memory M through the signal lines DL is contained in any of the plurality of target patterns which have been preset, and, when contained, determination which target pattern the bit string is. The occurrence rate table 13 has the data structure storing the patterns having high occurrence rates and the patterns having low occurrence rates.

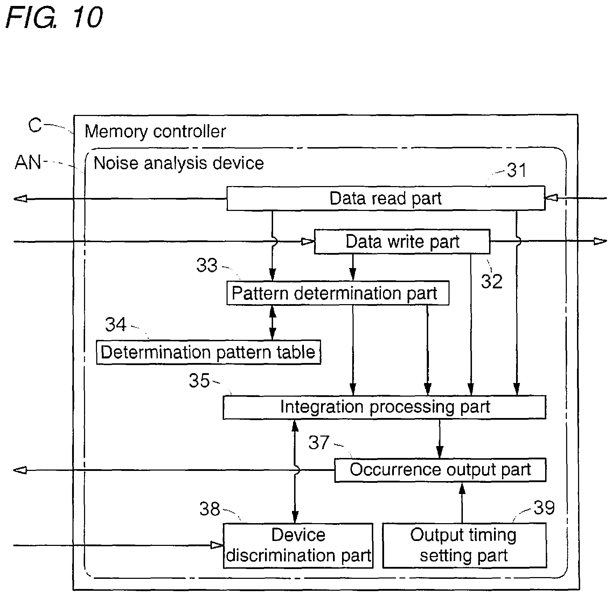

The occurrence rates are set based on occurrence rate information obtained in advance by the noise analysis device AN illustrated in FIG. 10. As described above, the memory controller C achieves processing according to the program, similar to a microprocessor, a DSP, and the like. With this configuration, the noise analysis device AN illustrated in FIG. 10 is configured by setting the program in the memory controller C. A dedicated computer and the like are connected to the noise analysis device AN, and the output occurrence rate information is obtained by the dedicated computer and the like and is stored in the occurrence rate table 13. Alternatively, the noise analysis device AN itself is preferably configured to generate or update the occurrence rate table 13 as appropriate, based on the occurrence rate information.

In the present embodiment, the noise analysis device AN includes a data read part 31, a data write part 32, a pattern determination part 33, a determination pattern table 34, an integration processing part 35, a occurrence output part 37, a device discrimination part 38, and an output timing setting part 39. Here, the pattern determination part 33 determines whether the pattern of the linear sequence of a bit of "1" and a bit of "0" of the bit string of the transmission data that is read from or is written into the memory M through the signal lines DL coincides with at least one of preset determination patterns. The determination pattern table 34 stores information on at least one of the preset determination patterns, more specifically, bit strings having the determination patterns. The integration processing part 35 obtains the number of occurrences of the determination pattern determined by the pattern determination part 33, as an integration value. The occurrence output part 37 outputs the occurrence rate information that the integration value obtained by the integration processing part 35 is associated with pattern identification information for identifying a determination pattern indicated by the integration value.

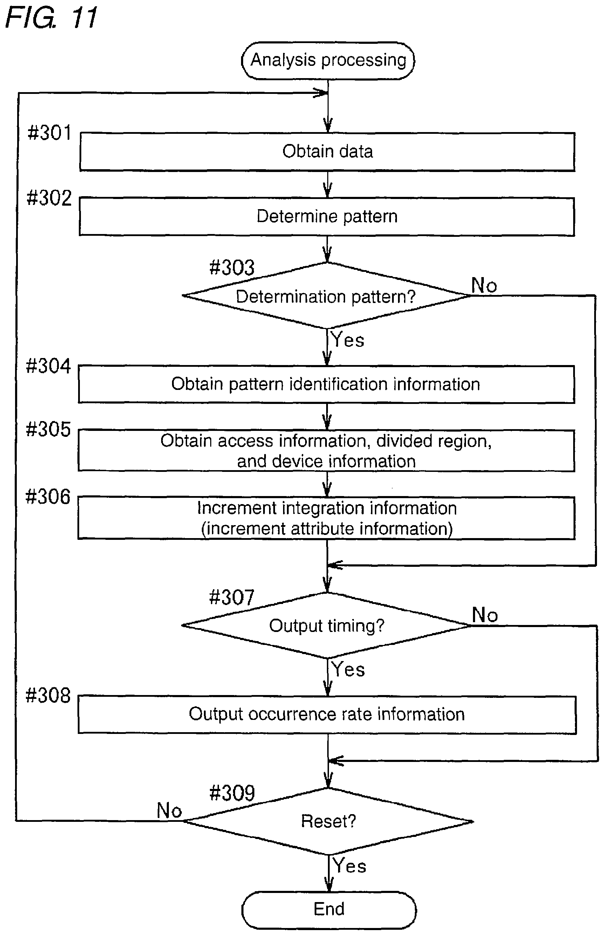

When various devices actually access data stored in the memory M, the noise analysis device AN obtains the patterns of the bit strings of a bit of "1" and a bit of "0" transmitted through the signal lines DL, and obtains an occurrence rate of each pattern. FIG. 11 is a flowchart illustrating an outline of this processing. A target from which the occurrence rate information is obtained is a bit string of transmission data that coincides with at least one of the determination patterns set to be analyzed.

In other words, when the bit string of the transmission data that is read from or is written into the memory M through the data read part 31 or the data write part 32 is transmitted through the signal lines DL, the pattern determination part 33 obtains the transmission data, and determines whether the transmission data coincides with at least one of the preset determination patterns, based on data in the determination pattern table 34 (steps #301 to #303).

Next, the integration processing part 35 obtains the number of occurrences of the determination pattern determined by the pattern determination part 33, as the integration value. In this case, the integration processing part 35 obtains the pattern identification information for identifying the determination pattern with respect to the transmission data that is determined to coincide with the determination patterns by the pattern determination part 33, and integrates the number of occurrences of each determination pattern. Further, in the present embodiment, the integration processing part 35 obtains the integration value while discriminating between a case in which data is written into the memory M and a case in which data is read from the memory M. Also, the integration processing part 35 obtains the integration value for each divided region, depending on which divided region, among a plurality of divided regions in a memory region in the memory M, stores the address in the memory M into which the transmission data is written. Furthermore, the integration processing part 35 obtains the integration value for each device, depending on which device, among a plurality of devices capable of accessing the memory M, corresponds to a device that is a transmission source of the transmission data. For that purpose, the integration processing part 35 obtains attribute information including access information, divided region information, and device information with respect to the transmission data that is determined to be the determination pattern by the pattern determination part 33. Then the integration processing part 35 integrates the number of occurrences of each determination pattern while associating the attribute information with the obtained pattern identification information, to obtain the integration value (steps #304 to #306).

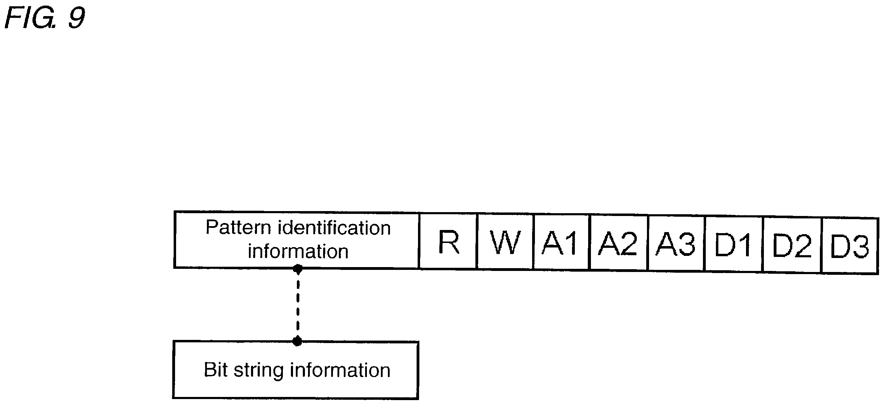

FIG. 9 illustrates an example of integration value data associated with the pattern identification information and the attribute information, which is obtained by the integration processing part 35. As illustrated in the same figure, in order to discriminate a plurality of kinds of determination patterns from each other, each set of the integration value data includes the pattern identification information as an index, and also includes, as the attribute information, the access information indicated by (R) and (W), the divided region information indicated by (A1 to A3), and the device information indicated by (D1 to D3). Further, the pattern identification information is associated with the bit string information of the determination pattern identified by the pattern identification information.

Specifically, (R) and (W) of the access information discriminatingly indicate the case (R) in which the data (bit string information) is written into the memory M and the case (W) in which the data (bit string information) is read from the memory M. (A1 to A3) of the divided region information indicate which divided region, among the plurality of divided regions (A1 to A3) in the memory region in the memory M, stores the address in the memory M into which the transmission data (bit string information) of the determination pattern is written. (D1 to D3) of the device information indicate which device, among the plurality of devices (D1 to D3) capable of accessing the memory M, corresponds to the device that is the transmission source of the transmission data (bit string information) of the determination pattern. Here, the device discrimination part 38 discriminates the device that is the transmission source from other devices, and sends the discrimination information to the integration processing part 36. The divided region information is not limited to the three regions described above, and also the number of devices is not limited to three.

The integration processing part 35 integrates the number of occurrences, for each determination pattern identified by the pattern identification information, and for each attribute information, and increments the integration value (step #306). Specifically, every time when the bit string of the transmission data, which is read from or written into the memory M, coincides with the determination pattern, the integration processing part 35 obtains the pattern identification information for the transmission data (bit string information), and obtains, as the attribute information, the access information indicated by (R) and (W), the divided region information indicated by (A1 to A3), and the device information indicated by (D1 to D3). The integration processing part 35 then increments any one of values of (R) and (W) of the access information, increments any one of values of (A1 to A3) of the divided region information, and increments any one of values of (D1 to D3) of the device information, for the data that is the integration value data and includes the pattern identification information for identifying the determination pattern, as illustrated in FIG. 9, in accordance with the obtained information.

Further, the occurrence output part 37 outputs the occurrence rate information at a preset output timing (steps #307, #308). Here, the occurrence rate information is information in which the integration value obtained by the integration processing part 35 is associated with the pattern identification information for identifying the determination pattern indicated by the integration value. In the present embodiment, the occurrence rate information is information in which the attribute information including the access information, the divided region information, and the device information is further associated with the integration value and the pattern identification information. Specifically, the occurrence output part 37 obtains the integration value data (refer to FIG. 9) at a moment that reaches the output timing from the integration processing part 35, and outputs the integration value data at the moment as the occurrence rate information. The processing from #301 to #308 is repeatedly executed until being reset (step #309).

The output timing setting part 39 gives trigger information for outputting to the occurrence output part 37 in accordance with the preset output timing. The occurrence output part 37 outputs the occurrence rate information in response to the trigger information. In the present embodiment, the output timing setting part 39 gives the trigger information for outputting to the occurrence output part 37, every time when the integration values generated by the integration processing part 35 exceed a preset output threshold value, or every time when an integration time period of the integration values exceeds a preset output time period. Specifically, the output timing setting part 39 outputs the trigger information to the occurrence output part 37, every time when the maximum value among the integration values respectively contained in the items in the integration value data illustrated in FIG. 9 exceeds the preset output threshold value, or every time when the integration time period of the integration values in the integration value data exceeds the preset output time period. It is noted that, the output timing setting part 39 may output the trigger information every time when both of the condition defined by a value in which the integration value exceeds the preset output threshold value and the condition defined by a time period in which the integration time period of the integration values in the integration value data exceeds the preset output time period are satisfied.

By sorting the integration values respectively contained in sets of the attribute information based on the occurrence rate information obtained through the analysis processing, the occurrence rate with any one of the access information, the divided region information, and the device information, or a combination thereof as a reference can be obtained.

For example, the memory region in the memory M may be divided into a plurality of divided regions in advance, and different kinds of data may be stored in each of the divided regions, depending on a device that uses the memory M such as a vehicle-mounted car navigation device. For example, a divided region that stores the data is predetermined for each kind of data in some cases such that a first divided region stores map information, a second divided region stores still image information, a third divided region stores audio information, and a fourth divided region stores program information. Similarly, the plurality of devices capable of accessing the memory M are present, and each device may transmit a different kind of data in some cases. For example, each device for accessing the memory M may transmit a different kind of data, such that, among the plurality of devices capable of accessing the memory M through the memory controller C, a map drawing device transmits map data, an image display device transmits still image data, an audio playback device transmits audio information, and an arithmetic processing device transmits program data. Then, in accordance with such a kind of data, non-uniformity of the occurrence rate of the combination pattern of a bit of "1" and a bit of "0" of the bit string of the data transmitted between the memory controller C and the memory M may be occurred, and the non-uniformity may have a certain fixed trend. Accordingly, the pattern whose occurrence rate is high in the bit string of the transmission data may also be different for each divided region in the memory M, or for each device for accessing the memory M.

Therefore, at least either the target pattern or the post-substitution pattern is preferably changed, depending on which divided region, among the plurality of divided regions in the memory region in the memory M, stores the address into which the transmission data is written, or depending on which device, among the plurality of devices capable of accessing the memory M, corresponds to the device that is the transmission source of the transmission data. For example, an occurrence rate for each divided region in the memory M is preferably obtained based on the occurrence rate information described above, and at least one of the patterns whose occurrence rates are higher than the criterion value E is preferably set as the target pattern and at least one of the patterns whose occurrence rates are lower than the criterion value E is preferably set as the post-substitution pattern, for each divided region storing the address into which the transmission data is written. Alternatively, an occurrence rate for each device that is the transmission source of the transmission data may be obtained based on the occurrence rate information, and at least one of the patterns whose occurrence rates are higher than the criterion value E may be set as the target pattern and at least one of the patterns whose occurrence rates are lower than the criterion value E may be set as the post-substitution pattern, for each device that is the transmission source of the transmission data.

### 2. Other Embodiments

(1) In the embodiment, the description is made of the example in which, when the plurality of data transmission lanes (DG1, DG2) are provided, the single target pattern and the single post-substitution pattern are set for each of the data transmission lanes (DG1, DG2). However, as a matter of course, it is preferable that a plurality of target patterns are set for each of the data transmission lanes (DG1, DG2), and the post-substitution pattern is set for each of the plurality of target patterns. As a matter of course, when the single data transmission lane is provided, the plurality of target patterns and a plurality of post-substitution patterns are preferably set to the single data transmission lane. Further, one or more common target patterns may be set to all of the data transmission lanes (DG1, DG2).
(2) In the embodiment, the description is made of the example in which each of the data transmission lanes (DG1, DG2) includes the plurality of signal lines DL. However, as a matter of course, each of the data transmission lanes (DG1, DG2) may be configured with a single signal line DL. In other words, the target pattern and the post-substitution pattern may be set to each signal line DL.
(3) In the embodiment, the description is made of the example in which the post-substitution pattern is set from the patterns whose occurrence rates are lower than the criterion value E. However, a configuration other than this configuration can be used. For example, the post-substitution pattern is preferably configured with a bit string in which only bits of "0" are continued or a bit string in which only bits of "1" are continued. By setting such post-substitution patterns, all of the substitutional bit strings have the same potential as one another in the signal lines DL, thereby effectively reducing the noise. Further, when such post-substitution patterns are used, the substitutional bit string in which either bits of "0" or bits of "1" are continued can be substituted for all of initial bit strings of a plurality of patterns that are likely to generate the noise. This simplifies the processing in the substitution unit 6b, thereby improving a speed of the processing.
(4) In the embodiment, the description is made of the case in which at least one of the patterns whose occurrence rates are higher than the criterion value E is set as the target pattern, and at least one of the patterns whose occurrence rates are lower than the criterion value E is set as the post-substitution pattern. However, the present invention is not limited to this configuration, and the target pattern and the post-substitution pattern may be set based on another criterion other than the occurrence rate. For example, it is preferable that at least one of patterns in which a pattern of a linear sequence of a bit of "1" and a bit of "0" of a bit string contained in data before the substitution performed by the substitution unit 6b generates noise having a predetermined noise frequency band is set as the target pattern, and at least one of patterns other than the patterns that generate the noise having the noise frequency band is set as the post-substitution pattern. When a frequency band whose noise is desired to reduce is already determined, those settings can effectively reduce the noise. When a plurality of patterns of bit strings that generate the noise having the frequency band desired to reduce are present, some or all of the patterns may be set as the target patterns.
(5) In the embodiment, the description is made of the example in which the occurrence rate information output from the occurrence output part 37 is the information associated with the integration value, the pattern identification information, and the attribute information. However, the occurrence rate information may be information associated with only the integration value and the pattern identification information. Further, in the embodiment, the description is made of the example in which the attribute information includes the access information, the divided region information, and the device information. However, the attribute information may include only a part of those sets of information, or may include information other than those sets of information.
(6) It is noted that, the configuration disclosed in each embodiment described above can be applied by combining with configurations disclosed in other embodiments unless a contradiction occurs. With respect to other configurations, the embodiments disclosed in the present specification are merely illustrations in all aspects. Accordingly, various changes and modifications may be achieved as appropriate without departing from the scope of the present disclosure.

### 3. Outline of Embodiments Described Above

Hereafter, an outline of the memory controller described above will be described.

A memory controller (C) includes a write part (6) that writes data into a memory (M) through a signal line (DL) by specifying an address of the memory (M), and a read part (7) that reads data from the memory (M) through the signal line (DL) by specifying an address of the memory (M), in which
the write part (M) includes a substitution unit (6b) that substitutes, when a linear sequence of a bit of "1" and a bit of "0" of a bit string of transmission data to be written into the memory (M) through the signal line (DL) is a target pattern set as a substitution target, a substitutional bit string that is a post-substitution pattern whose linear sequence of the bit of "1" and the bit of "0" is different from the target pattern, for an initial bit string having the target pattern, before the transmission data is written into the memory (M), and
the read part (7) includes a restoration unit (7b) that restores the substitutional bit string of data read from the memory (M) to the initial bit string.

According to this configuration, by appropriately setting the target pattern and the post-substitution pattern, another pattern can be substituted for a bit string pattern that generates noise causing a problem. Therefore noise generated in the signal line (DL) can be reduced in both a case in which data is written into the memory (M) and a case in which data is read from the memory (M).

Further, in this case, by only modifying settings of the target pattern and the post-substitution pattern in software, noise having various frequencies can be reduced. Accordingly, in comparison with a case in which noise countermeasures are taken by, for example, providing a shield that covers the signal line (DL), or by circuit design, a noise frequency to be reduced can be easily changed. Thus, the noise countermeasure can be flexibly taken in accordance with usage environments of the memory (M) and the memory controller (C).

Furthermore, according to this configuration, the function of the substitution unit (6b) and the function of the restoration unit (7b) have only to be implemented in the memory controller (C), and a typical memory can be used as the memory (M). The software settings are conducted only in the memory controller (C), and thus procedures of the software settings can be simplified.

It is preferable that the substitution unit (6b) includes:
a pattern determination module (12) that determines whether a linear sequence of a bit of "1" and a bit of "0" of a bit string of the transmission data is the target pattern;
a substitution module (11) that substitutes the substitutional bit string for the initial bit string, when the pattern determination module (12) determines that the linear sequence is the target pattern; and
a storage module (14) that stores the target pattern and address data which are associated with each other, when the substitution module (11) performs the substitution, the address data identifying an address in the memory (M) into which the substitutional bit string is written, and
the restoration unit (7b) preferably includes;
an identification module (22) that identifies the substitutional bit string contained in the data read from the memory (M), based on the address data; and
a restoration module (21) that restores the substitutional bit string to the initial bit string before being substituted, based on the target pattern associated with the address data.

According to this configuration, when the pattern determination module (12) determines that the transmission data to be written into the memory (M) is the target pattern, the substitution module (11) substitutes the substitutional bit string for the initial bit string having the target pattern, and the substitutional bit string rewritten in such a manner is written into the memory (M). Further, upon substituting, the target pattern and the address data are associated with each other to be stored in a predetermined memory part and the like by the storage module (14). After that, when the identification module (22) determines that the substitutional bit string is contained in the data read from the memory (M), the substitutional bit string is restored to the initial bit string by the restoration module (21).

Furthermore, it is preferable that at least one of patterns is set as the target pattern, the at least one of patterns being a pattern in which an occurrence rate of a pattern of a linear sequence of a bit of "1" and a bit of "0" of a bit string contained in data before the substitution performed by the substitution unit (6b) is higher than a predetermined criterion value (E), and
at least one of patterns whose occurrence rates are lower than the criterion value (E) is set as the post-substitution pattern.

According to this configuration, the patterns whose occurrence rates are lower than the criterion value (E) can be substituted for the patterns whose occurrence rates are higher than the criterion value (E) to perform the transmission through the signal line (DL). This can reduce patterns of bit strings that have a high possibility of generating noise due to their high occurrence rates, thereby reducing the noise generated in the signal line (DL).

Alternatively, it is preferable that at least one of patterns in which a pattern of a linear sequence of a bit of "1" and a bit of "0" of a bit string contained in data before the substitution performed by the substitution unit (6b) generates noise having a predetermined noise frequency band is set as the target pattern, and
at least one of patterns other than the patterns that generate the noise having the noise frequency band is set as the post-substitution pattern.

According to this configuration, bit strings of patterns that do not generate the noise having the predetermined noise frequency band can be substituted for the patterns of the bit strings that generate the noise having the predetermined noise frequency band to perform the transmission through the signal line (DL). Accordingly, the patterns of the bit strings that generate the noise having the specific frequency band desired to reduce can be reduced, and the noise having the specific frequency band generated in the signal line (DL) can be reduced. When the frequency band whose noise is desired to reduce is already determined, those settings can effectively reduce the noise.

Furthermore, it is preferable that a plurality of the signal lines (DL) are provided, and a plurality of data transmission lanes that include at least a first transmission lane (DG1) and a second transmission lane (DG2) are configured with the plurality of the signal lines (DL), and
the substitution unit (6b) sets a different post-substitution pattern to each of the first transmission lane (DG1) and the second transmission lane (DG2), such that an on/off frequency generated by a linear sequence of a bit of "1" and a bit of "0" of the substitutional bit string transmitted through the first transmission lane (DG1) is different from an on/off frequency generated by a linear sequence of a bit of "1" and a bit of "0" of the substitutional bit string transmitted through the second transmission lane (DG2).

According to this configuration, the on/off frequencies of the substitutional bit strings in the plurality of data transmission lanes can be distributed. This suppresses an increase in the noise having the specific frequency by the substitution processing performed by the substitution unit (6b).

Furthermore, it is preferable that a plurality of the signal lines (DL) are provided, and a plurality of data transmission lanes that include at least a first transmission lane (DG1) and a second transmission lane (DG2) are configured with the plurality of the signal lines (DL), and
the substitution unit (6b) sets a different post-substitution pattern to each of the first transmission lane (DG1) and the second transmission lane (DG2), such that a timing of a boundary between a bit of "1" and a bit of "0" of the substitutional bit string transmitted through the first transmission lane (DG1) is different from a timing of a boundary between a bit of "1" and a bit of "0" of the substitutional bit string transmitted through the second transmission lane (DG2).

This configuration can suppress the noise increased at a timing when timings of boundaries between bits of "1" and bits of "0" of the post-substitution bit strings in the plurality of data transmission lanes (DG1, DG2) are the same as each other, after the substitution processing performed by the substitution unit (6b).

It is preferable that the write part (6) changes at least either the target pattern or the post-substitution pattern, depending on which divided region, among a plurality of divided regions in a memory region in the memory (M), stores the address in the memory into which the transmission data is written, or depending on which device, among a plurality of devices capable of accessing the memory (M), corresponds to a device that is a transmission source of the transmission data.

The memory region in the memory (M) may be divided into the plurality of divided regions in advance, and different kinds of data may be stored in each of the divided regions, depending on a device that uses the memory (M). Further, the plurality of devices capable of accessing the memory (M) may be present, and each device may transmit different kinds of data. Then, in accordance with such a kind of data, non-uniformity of the occurrence rate of the combination pattern of a bit of "1" and a bit of "0" of the bit string of the data transmitted between the memory controller (C) and the memory (M) may be occurred, and the non-uniformity may have a certain fixed trend. Accordingly, the pattern whose occurrence rate is high in the bit string of the transmission data may also be different for each divided region in the memory (M), or for each device for accessing the memory (M). According to the configuration described above, at least either the target pattern or the post-substitution pattern can be appropriately set in accordance with the non-uniformity for each kind of data. Accordingly, the noise generated in the signal lines (DL) can be efficiently reduced.

Further, the post-substitution pattern is preferably configured with a bit string in which only bits of "0" are continued or a bit string in which only bits of "1" are continued.

According to this configuration, all of the substitutional bit strings have the same potential as one another in the signal lines (DL), thereby effectively reducing the noise. Further, when such a post-substitution pattern is used, a substitutional bit string in which either bits of "0" or bits of "1" are continued can be substituted for all of initial bit strings of a plurality of patterns that are likely to generate the noise. This simplifies the processing in the substitution unit (6b), thereby improving a processing speed thereof.

### INDUSTRIAL APPLICABILITY

The techniques according to the present disclosure can be applied to a memory controller that performs data transmission to a memory through a signal line.

### REFERENCE SIGNS LIST

- 6: Write part
- 6b: Substitution unit
- 7: Read part
- 7b: Restoration unit
- 11: Substitution module
- 12: Pattern determination module
- 14: Storage processing module
- 21: Restoration module
- D: Data bus
- DL: Signal line
- DG1: First transmission lane
- DG2: Second transmission lane
- E: Criterion value
- M: Memory

## Claims

1. A memory controller (C) comprising:
a write part (6) that writes data into a memory (M) through a signal line (DL) by specifying an address of the memory; and
a read part (7) that reads data from the memory through the signal line by specifying an address of the memory,
wherein
the write part includes a substitution unit (6b) that substitutes, when a linear sequence of a bit of "1" and a bit of "0" of a bit string of transmission data to be written into the memory through the signal line is a target pattern set as a substitution target, a substitutional bit string that is a post-substitution pattern whose linear sequence of a bit of "1" and a bit of "0" is different from the target pattern, for an initial bit string having the target pattern, before the transmission data is written into the memory, and
the read part includes a restoration unit (7b) that restores the substitutional bit string of data read from the memory to the initial bit string,
**characterized in that** at least one of patterns is set as the target pattern, the at least one of patterns being a pattern in which a pattern of a linear sequence of a bit of "1" and a bit of "0" of a bit string contained in data before the substitution performed by the substitution unit generates noise having a predetermined noise frequency band, and
at least one of patterns other than the patterns that generate the noise having the noise frequency band is set as the post-substitution pattern.

2. A memory controller (C) comprising:
a write part (6) that writes data into a memory (M) through a signal line (DL) by specifying an address of the memory; and
a read part (7) that reads data from the memory through the signal line by specifying an address of the memory,
wherein
the write part includes a substitution unit (6b) that substitutes, when a linear sequence of a bit of "1" and a bit of "0" of a bit string of transmission data to be written into the memory through the signal line is a target pattern set as a substitution target, a substitutional bit string that is a post-substitution pattern whose linear sequence of a bit of "1" and a bit of "0" is different from the target pattern, for an initial bit string having the target pattern, before the transmission data is written into the memory, and
the read part includes a restoration unit (7b) that restores the substitutional bit string of data read from the memory to the initial bit string,
**characterized in that** a plurality of the signal lines (DL) are provided, and a plurality of data transmission lanes that include at least a first transmission lane (DG1) and a second transmission lane (DG2) are configured with the plurality of the signal lines, and
the substitution unit (6b) sets a different post-substitution pattern to each of the first transmission lane and the second transmission lane, such that an on/off frequency generated by a linear sequence of the bit of "1" and the bit of "0" of the substitutional bit string transmitted through the first transmission lane is different from an on/off frequency generated by a linear sequence of the bit of "1" and the bit of "0" of the substitutional bit string transmitted through the second transmission lane.

3. A memory controller (C) comprising:
a write part (6) that writes data into a memory (M) through a signal line (DL) by specifying an address of the memory; and
a read part (7) that reads data from the memory through the signal line by specifying an address of the memory,
wherein
the write part includes a substitution unit (6b) that substitutes, when a linear sequence of a bit of "1" and a bit of "0" of a bit string of transmission data to be written into the memory through the signal line is a target pattern set as a substitution target, a substitutional bit string that is a post-substitution pattern whose linear sequence of a bit of "1" and a bit of "0" is different from the target pattern, for an initial bit string having the target pattern, before the transmission data is written into the memory, and
the read part includes a restoration unit (7b) that restores the substitutional bit string of data read from the memory to the initial bit string,
**characterized in that** a plurality of the signal lines (DL) are provided, and a plurality of data transmission lanes that include at least a first transmission lane and a second transmission lane are configured with the plurality of the signal lines, and
the substitution unit (6b) sets a different post-substitution pattern to each of the first transmission lane and the second transmission lane, such that a timing of a boundary between the bit of "1" and the bit of "0" of the substitutional bit string transmitted through the first transmission lane is different from a timing of a boundary between the bit of "1" and the bit of "0" of the substitutional bit string transmitted through the second transmission lane.

4. The memory controller according to any one of claims 1 to 3, wherein
the substitution unit (6b) includes
a pattern determination module (12) that determines whether the linear sequence of the bit of "1" and the bit of "0" of the bit string of the transmission data is the target pattern,
a substitution module (11) that substitutes the substitutional bit string for the initial bit string, when the pattern determination module determines that the linear sequence is the target pattern, and
a storage module (14) that stores the target pattern and address data associated with each other, when substitution is performed by the substitution module, the address data identifying an address in the memory into which the substitutional bit string is written, and
the restoration unit (7b) includes
an identification module (22) that identifies the substitutional bit string contained in data read from the memory, based on the address data, and
a restoration module (21) that restores the substitutional bit string to the initial bit string before being substituted, based on the target pattern associated with the address data.

5. The memory controller according to any one of claims 1 to 4, wherein
at least one of patterns is set as the target pattern, the at least one of patterns being a pattern in which an occurrence rate of a pattern of a linear sequence of a bit of "1" and a bit of "0" of a bit string contained in data before the substitution performed by the substitution unit is higher than a predetermined criterion value, and
at least one of patterns whose occurrence rates are lower than the criterion value is set as the post-substitution pattern.

6. The memory controller according to any one of claims 1 to 5, wherein
the write part (6) changes at least either the target pattern or the post-substitution pattern, depending on which divided region, among a plurality of divided regions in a memory region in the memory (M), stores the address into which the transmission data is written, or depending on which device, among a plurality of devices capable of accessing the memory, corresponds to a device that is a transmission source of the transmission data.

7. The memory controller according to any one of claims 1 to 6, wherein
the post-substitution pattern is configured with a bit string in which only bits of "0" are continued or a bit string in which only bits of "1" are continued.

## Patentansprüche

1. Speicher-Steuereinheit (C), umfassend:
einen Schreibteil (6), der über eine Signalleitung (DL) Daten in einen Speicher (M) schreibt, indem er eine Adresse des Speichers spezifiziert, und
einen Leseteil (7), der über die Signalleitung Daten aus dem Speicher liest, indem er eine Adresse des Speichers spezifiziert,
wobei
der Schreibteil eine Ersetzungseinheit (6b) enthält, die, wenn eine lineare Sequenz eines Bits von "1" und eines Bits von "0" einer Bit-Kette von Sendedaten, die über die Signalleitung in den Speicher geschrieben werden sollen, ein Zielmuster ist, das als ein Ersetzungsziel eingestellt ist, eine Ersetzungs-Bit-Kette, die ein Nach-Ersetzungs-Muster ist, dessen lineare Sequenz eines Bits von "1" und eines Bits von "0" von dem Zielmuster verschieden ist, an die Stelle einer Anfangs-Bit-Kette setzt, die das Zielmuster aufweist, bevor die Sendedaten in den Speicher geschrieben werden, und
der Leseteil eine Wiederherstellungseinheit (7b) enthält, welche die Ersetzungs-Bit-Kette von Daten, die aus dem Speicher gelesen wurden, zu der Anfangs-Bit-Kette wiederherstellt,
**dadurch gekennzeichnet, dass** mindestens eines von Mustern als das Zielmuster eingestellt wird, wobei das mindestens eine von Mustern ein Muster ist, in dem ein Muster einer linearen Sequenz eines Bits von "1" und eines Bits von "0" einer Bit-Kette, die in Daten vor der durch die Ersetzungseinheit ausgeführten Ersetzung enthalten ist, Rauschen erzeugt, das ein zuvor festgelegtes Rauschfrequenzband aufweist, und
mindestens eines von anderen Mustern als die Muster, die das Rauschen erzeugen, welches das Rauschfrequenzband aufweist, als das Nach-Ersetzungs-Muster eingestellt wird.

2. Speicher-Steuereinheit (C), umfassend:
einen Schreibteil (6), der über eine Signalleitung (DL) Daten in einen Speicher (M) schreibt, indem er eine Adresse des Speichers spezifiziert, und
einen Leseteil (7), der über die Signalleitung Daten aus dem Speicher liest, indem er eine Adresse des Speichers spezifiziert,
wobei
der Schreibteil eine Ersetzungseinheit (6b) enthält, die, wenn eine lineare Sequenz eines Bits von "1" und eines Bits von "0" einer Bit-Kette von Sendedaten, die über die Signalleitung in den Speicher geschrieben werden sollen, ein Zielmuster ist, das als ein Ersetzungsziel eingestellt ist, eine Ersetzungs-Bit-Kette, die ein Nach-Ersetzungs-Muster ist, dessen lineare Sequenz eines Bits von "1" und eines Bits von "0" von dem Zielmuster verschieden ist, an die Stelle einer Anfangs-Bit-Kette setzt, die das Zielmuster aufweist, bevor die Sendedaten in den Speicher geschrieben werden, und
der Leseteil eine Wiederherstellungseinheit (7b) enthält, welche die Ersetzungs-Bit-Kette von Daten, die aus dem Speicher gelesen wurden, zu der Anfangs-Bit-Kette wiederherstellt,
**dadurch gekennzeichnet, dass** mehrere der Signalleitungen (DL) vorhanden sind und mehrere Datenübertragungsbahnen, die mindestens eine erste Übertragungsbahn (DG1) und eine zweite Übertragungsbahn (DG2) enthalten, mit den mehreren der Signalleitungen konfiguriert sind, und
die Ersetzungseinheit (6b) ein anderes Nach-Ersetzungs-Muster für jede der ersten Übertragungsbahn und der zweiten Übertragungsbahn einstellt, dergestalt, dass eine Ein/Aus-Frequenz, die durch eine lineare Sequenz des Bits von "1" und des Bits von "0" der Ersetzungs-Bit-Kette erzeugt wird, die durch die erste Übertragungsbahn gesendet wird, von einer Ein/Aus-Frequenz verschieden ist, die durch eine lineare Sequenz des Bits von "1" und des Bits von "0" der Ersetzungs-Bit-Kette erzeugt wird, die durch die zweite Übertragungsbahn gesendet wird.

3. Speicher-Steuereinheit (C), umfassend:
einen Schreibteil (6), der über eine Signalleitung (DL) Daten in einen Speicher (M) schreibt, indem er eine Adresse des Speichers spezifiziert, und
einen Leseteil (7), der über die Signalleitung Daten aus dem Speicher liest, indem er eine Adresse des Speichers spezifiziert,
wobei
der Schreibteil eine Ersetzungseinheit (6b) enthält, die, wenn eine lineare Sequenz eines Bits von "1" und eines Bits von "0" einer Bit-Kette von Sendedaten, die über die Signalleitung in den Speicher geschrieben werden sollen, ein Zielmuster ist, das als ein Ersetzungsziel eingestellt ist, eine Ersetzungs-Bit-Kette, die ein Nach-Ersetzungs-Muster ist, dessen lineare Sequenz eines Bits von "1" und eines Bits von "0" von dem Zielmuster verschieden ist, an die Stelle einer Anfangs-Bit-Kette setzt, die das Zielmuster aufweist, bevor die Sendedaten in den Speicher geschrieben werden, und
der Leseteil eine Wiederherstellungseinheit (7b) enthält, welche die Ersetzungs-Bit-Kette von Daten, die aus dem Speicher gelesen wurden, zu der Anfangs-Bit-Kette wiederherstellt,
**dadurch gekennzeichnet, dass** mehrere der Signalleitungen (DL) vorhanden sind und mehrere Datenübertragungsbahnen, die mindestens eine erste Übertragungsbahn und eine zweite Übertragungsbahn enthalten, mit den mehreren der Signalleitungen konfiguriert sind, und
die Ersetzungseinheit (6b) ein anderes Nach-Ersetzungs-Muster für jede der ersten Übertragungsbahn und der zweiten Übertragungsbahn einstellt, dergestalt, dass ein Zeitpunkt einer Grenze zwischen dem Bit von "1" und dem Bit von "0" der Ersetzungs-Bit-Kette, die durch die erste Übertragungsbahn gesendet wird, ein anderer ist als ein Zeitpunkt einer Grenze zwischen dem Bit von "1" und dem Bit von "0" der Ersetzungs-Bit-Kette, die durch die zweite Übertragungsbahn gesendet wird.

4. Speicher-Steuereinheit nach einem der Ansprüche 1 bis 3, wobei die Ersetzungseinheit (6b) enthält:
ein Musterbestimmungsmodul (12), das bestimmt, ob die lineare Sequenz des Bits von "1" und des Bits von "0" der Bit-Kette der Sendedaten das Zielmuster ist,
ein Ersetzungsmodul (11), das die Ersetzungs-Bit-Kette an die Stelle der Anfangs-Bit-Kette setzt, wenn das Musterbestimmungsmodul bestimmt, dass die lineare Sequenz das Zielmuster ist, und
ein Speichermodul (14), das das Zielmuster und Adressdaten speichert, die miteinander verknüpft sind, wenn eine Ersetzung durch das Ersetzungsmodul ausgeführt wird, wobei die Adressdaten eine Adresse in dem Speicher identifizieren, in den die Ersetzungs-Bit-Kette geschrieben wird, und
die Wiederherstellungseinheit (7b) enthält:
ein Identifizierungsmodul (22), das die Ersetzungs-Bit-Kette, die in Daten enthalten ist, die aus dem Speicher gelesen werden, anhand der Adressdaten identifiziert, und
ein Wiederherstellungsmodul (21), das die Ersetzungs-Bit-Kette anhand des Zielmusters, das mit den Adressdaten verknüpft ist, zu der Anfangs-Bit-Kette wiederherstellt, bevor sie ersetzt wird.

5. Speicher-Steuereinheit nach einem der Ansprüche 1 bis 4, wobei
mindestens eines von Mustern als das Zielmuster eingestellt wird, wobei das mindestens eine von Mustern ein Muster ist, in dem eine Häufigkeitsrate eines Musters einer linearen Sequenz eines Bits von "1" und eines Bits von "0" einer Bit-Kette, die in Daten vor der durch die Ersetzungseinheit ausgeführten Ersetzung enthalten ist, höher ist als ein zuvor festgelegter Kriteriumwert, und
mindestens eines von Mustern, deren Häufigkeitsraten niedriger sind als der Kriteriumwert, als das Nach-Ersetzungs-Muster eingestellt wird.

6. Speicher-Steuereinheit nach einem der Ansprüche 1 bis 5, wobei der Schreibteil (6) mindestens entweder das Zielmuster oder das Nach-Ersetzungs-Muster in Abhängigkeit davon ändert, welche geteilte Region unter mehreren geteilten Regionen in einer Speicherregion in dem Speicher (M) die Adresse speichert, in die die Sendedaten geschrieben werden, oder in Abhängigkeit davon, welche Vorrichtung unter mehreren Vorrichtungen, die auf den Speicher zugreifen können, einer Vorrichtung entspricht, die eine Sendequelle der Sendedaten ist.

7. Speicher-Steuereinheit nach einem der Ansprüche 1 bis 6, wobei das Nach-Ersetzungs-Muster mit einer Bit-Kette konfiguriert wird, in der nur Bits von "0" fortgesetzt werden, oder mit einer Bit-Kette konfiguriert wird, in der nur Bits von "1" fortgesetzt werden.

## Revendications

1. Contrôleur de mémoire (C) comprenant :
une partie d'écriture (6) qui écrit des données dans une mémoire (M) à l'aide d'une ligne de signal (DL) en spécifiant une adresse de la mémoire ; et
une partie de lecture (7) qui lit des données depuis la mémoire à l'aide de la ligne de signal en spécifiant une adresse de la mémoire,
dans lequel
la partie d'écriture comprend une unité de substitution (6b) qui remplace, lorsqu'une séquence linéaire d'un bit de « 1 » et d'un bit de « 0 » d'une chaîne de bits de données de transmission à écrire dans la mémoire à l'aide de la ligne de signal est un modèle cible défini comme une cible de substitution, une chaîne de bits de substitution qui est un modèle de post-substitution dont la séquence linéaire d'un bit de « 1 » et d'un bit de « 0 » est différente du modèle cible, pour une chaîne de bits initiale ayant le modèle cible, avant que les données de transmission soient écrites dans la mémoire, et
la partie de lecture comprend une unité de restauration (7b) qui restaure la chaîne de bits de substitution des données lues depuis la mémoire en la chaîne de bits initiale,
**caractérisé en ce qu'**au moins l'un des modèles est défini comme le modèle cible, le au moins l'un des modèles étant un modèle dans lequel un modèle d'une séquence linéaire d'un bit de « 1 » et d'un bit de « 0 » d'une chaîne de bits contenue dans les données avant la substitution effectuée par l'unité de substitution génère un bruit ayant une bande de fréquence de bruit prédéterminée, et
au moins l'un des modèles autre que les modèles qui génèrent le bruit ayant la bande de fréquence de bruit est défini comme le modèle de post-substitution.

2. Contrôleur de mémoire (C) qui comprend :
une partie d'écriture (6) qui écrit des données dans une mémoire (M) à l'aide d'une ligne de signal (DL) en spécifiant une adresse de la mémoire ; et
une partie de lecture (7) qui lit des données depuis la mémoire à l'aide de la ligne de signal en spécifiant une adresse de la mémoire,
dans lequel
la partie d'écriture comprend une unité de substitution (6b) qui remplace, lorsqu'une séquence linéaire d'un bit de « 1 » et d'un bit de « 0 » d'une chaîne de bits de données de transmission à écrire dans la mémoire à l'aide de la ligne de signal est un modèle cible défini comme un modèle de substitution, une chaîne de bits de substitution qui est un modèle de post-substitution dont la séquence linéaire d'un bit de « 1 » et d'un bit de « 0 » est différente du modèle cible, pour une chaîne de bits initiale ayant le modèle cible, avant que les données de transmission soient écrites dans la mémoire, et
la partie de lecture comprend une unité de restauration (7b) qui restaure la chaîne de bits de substitution des données lues depuis la mémoire en la chaîne de bits initiale,
**caractérisé en ce qu'**une pluralité de lignes de signaux (DL) sont prévues, et une pluralité de canaux de transmission de données qui comprennent au moins un premier canal de transmission (DG1) et un second canal de transmission (DG2) sont configurés avec la pluralité de lignes de signaux, et
l'unité de substitution (6b) définit un modèle de post-substitution différent pour chacun du premier canal de transmission et du second canal de transmission, de sorte qu'une fréquence d'activation/de désactivation générée par une séquence linéaire du bit de « 1 » et du bit de « 0 » de la chaîne de bits de substitution transmise à l'aide du premier canal de transmission soit différente d'une fréquence d'activation/de désactivation générée par une séquence linéaire du bit de « 1 » et du bit de « 0 » de la chaîne de bits de substitution transmise à l'aide du second canal de transmission.

3. Contrôleur de mémoire (C) comprenant :
une partie d'écriture (6) qui écrit des données dans une mémoire (M) à l'aide d'une ligne de signal (DL) en spécifiant une adresse de la mémoire ; et
une partie de lecture (7) qui lit des données depuis la mémoire à l'aide de la ligne de signal en spécifiant une adresse de la mémoire,
dans lequel
la partie d'écriture comprend une unité de substitution (6b) qui remplace, lorsqu'une séquence linéaire d'un bit de « 1 » et d'un bit de « 0 » d'une chaîne de bits de données de transmission à écrire dans la mémoire à l'aide de la ligne de signal est un modèle cible défini comme un modèle de substitution, une chaîne de bits de substitution qui est un modèle de post-substitution dont la séquence linéaire d'un bit de « 1 » et d'un bit de « 0 » est différente du modèle cible, pour une chaîne de bits initiale ayant le modèle cible, avant que les données de transmission soient écrites dans la mémoire, et
la partie de lecture comprend une unité de restauration (7b) qui restaure la chaîne de bits de substitution des données lues depuis la mémoire en la chaîne de bits initiale,
**caractérisé en ce qu'**une pluralité de lignes de signaux (DL) sont prévues, et une pluralité de canaux de transmission de données qui comprennent au moins un premier canal de transmission et un second canal de transmission sont configurés avec la pluralité de lignes de signaux, et
l'unité de substitution (6b) définit un modèle de post-substitution différent pour chacun du premier canal de transmission et du second canal de transmission, de sorte qu'une synchronisation d'une limite entre le bit de « 1 » et le bit de « 0 » de la chaîne de bits de substitution transmise à l'aide du premier canal de transmission soit différente d'une synchronisation d'une limite entre le bit de « 1 » et le bit de « 0 » de la chaîne de bits de substitution transmise à l'aide du second canal de transmission.

4. Contrôleur de mémoire selon l'une quelconque des revendications 1 à 3, dans lequel
l'unité de substitution (6b) comprend
un module de détermination de modèle (12) qui détermine si la séquence linéaire du bit de « 1 » et du bit de « 0 » de la chaîne de bits des données de transmission est le modèle cible,
un module de substitution (11) qui remplace la chaîne de bits de substitution par la chaîne de bits initiale, lorsque le module de détermination de modèle détermine que la séquence linéaire est le modèle cible, et
un module de stockage (14) qui stocke le modèle cible et les données d'adresse associées les unes aux autres, lorsqu'une substitution est effectuée par le module de substitution, les données d'adresse identifiant une adresse dans la mémoire dans laquelle la chaîne de bits de substitution est écrite, et
l'unité de restauration (7b) comprend
un module d'identification (22) qui identifie la chaîne de bits de substitution contenues dans les données lues depuis la mémoire, sur la base des données d'adresse, et
un module de restauration (21) qui restaure la chaîne de bits de substitution en la chaîne de bits initiale avant d'être remplacée, sur la base du modèle cible associé aux données d'adresse.

5. Contrôleur de mémoire selon l'une quelconque des revendications 1 à 4, dans lequel
au moins l'un des modèles est défini comme le modèle cible, le au moins l'un des modèles étant un modèle dans lequel un taux d'occurrence d'une séquence linéaire d'un bit de « 1 » et d'un bit de « 0 » d'une chaîne de bits contenue dans les données avant que la substitution soit effectuée par l'unité de substitution est supérieur à une valeur de critère prédéterminée, et
au moins l'un des modèles dont les taux d'occurrence sont inférieurs à la valeur de critère est défini comme le modèle de post-substitution.

6. Contrôleur de mémoire selon l'une quelconque des revendications 1 à 5, dans lequel
la partie d'écriture (6) change au moins le modèle cible ou le modèle de post-substitution, selon la zone divisée, parmi une pluralité de zones divisées dans une zone de mémoire dans la mémoire (M), stocke l'adresse à laquelle les données de transmission sont écrites, ou selon le dispositif, parmi une pluralité de dispositifs capables d'accéder à la mémoire, correspond à un dispositif qui est une source de transmission des données de transmission.

7. Contrôleur de mémoire selon l'une quelconque des revendications 1 à 6, dans lequel
le modèle de post-substitution est configuré avec une chaîne de bits dans laquelle seuls les bits de « 0 » sont poursuivis, ou une chaîne de bits dans laquelle seuls les bits de « 1 » sont poursuivis.
